# EUROPEAN PATENT APPLICATION

(11) **EP 1 061 575 A1**
(43) Date of publication of application: **20.12.2000**
(21) Application number: 99830368.9
(22) Date of filing: 15.06.1999
(51) Int. Cl.: H01L 23/495, C25D 5/50, H01L 21/48, H01L 21/60, H01L 23/488

(54) **Process for plating metal parts of semiconductor devices**

(71) Applicant: STMicroelectronics S.r.l., 20041 Agrate Brianza (Milano) (IT)
(72) Inventor: Crema, Paolo, 20059 Vimercate (Milano) (IT)
(74) Representative: Maggioni, Claudio

(57) **Abstract**

The process comprises, in succession, the application of a layer of tin to the metal parts, heating to a temperature such that at least one predetermined region of the tin is melted, and cooling to a temperature such that the tin melted in the preceding stage is solidified. To prevent short circuits between adjacent strips and damaging thermal shocks to the devices, the heating stage is carried out by means of laser radiation.

## Description

The present invention relates to a process for plating metal parts of semiconductor devices and, in particular, for tin-plating metal parts.

In the manufacture of electronic systems comprising integrated circuits and other semiconductor devices mounted on printed circuit boards, the connections between the terminals of the components and the metal tracks of the printed circuit are commonly made by soldering.

In a very widely used method, soldering is carried out by using as the soldering material a low-melting alloy formed previously in a thin layer on the metal strips forming the terminal conductors of the devices to be connected to the printed circuit. This layer is usually formed in a processing stage immediately preceding the separation of the individual devices by cutting the metal portions which hold them together in a single lead frame. For this purpose, plating methods such as, for example, those using electrolytic baths are used.

If the soldering material is deposited on the metal strips by electrolysis, a washing stage is normally required to remove the residues of the solution used in the electrolytic bath.

After the washing stage, the devices, still joined together or separated, are stored while awaiting further processing or soldering to a printed circuit board.

The soldering material which is most commonly used at present consists essentially of an alloy of tin and lead. The use of lead in these alloys, however, gives rise to the well-known problem of environmental pollution and the toxicity of this metal.

Alternative alloys, such as tin and bismuth, tin and zinc, tin and silver, and tin and copper have been proposed to resolve the aforesaid problem.

The preferred solution, however, would be to use pure tin, since tin, owing to its chemical and physical characteristics, can be used to produce soldered joints which are particularly reliable in terms of mechanical strength and electrical conduction. Furthermore, electrolytic baths for tin plating are well known and have been tested.

However, this solution entails a disadvantage in that pure tin tends to spontaneously form "whiskers", in other words filaments a few microns in diameter and several millimetres in length.

The growth of these filaments takes place in normal environmental conditions, for example during the storage period.

The presence of filaments between the adjacent metal strips of the electronic devices causes short circuits when the distance between the strips is rather small, of the order of a few tens of microns for example.

It is known that the formation of whiskers can be avoided by melting and reconsolidating the tin after plating. Before this operation, the plated surfaces must be subjected to a treatment known as fluxing, to eliminate the thin layer of tin oxide which forms on them during exposure to the air.

This stage of melting, or remelting as it is usually called, is carried out by subjecting the whole metal frame, with the electronic devices formed on it, to a high temperature, and is followed by a cooling stage to reconsolidate the tin.

This treatment cannot always be carried out, since the thermal shock which it causes can adversely affect the reliability of the electronic devices; moreover, it cannot be used in cases in which the distance between the metal strips which form the terminals of the devices is very small, since the remelted tin may form short circuits between adjacent strips.

The object of the present invention is to propose a plating process which has characteristics such that the disadvantages inherent in the plating systems according to the prior art can be overcome, while at the same time the aforesaid environmental and health requirements can be met.

This object is achieved with a plating process as defined and characterized in a general way in the first claim.

Further characteristics and advantages of the process according to the invention will be made clear by the following description of a preferred embodiment of the invention, provided for information and without restriction.

In the manufacture of integrated circuits in plastic "packages", as is known, a multiplicity of devices is mounted on a metal frame (lead frame) formed by cutting from a sheet, of copper for example.

The plastic housings containing the active parts of the devices are formed by injecting an epoxy resin under pressure into a mould. The metal frame with the plastic housings formed on it is extracted from the mould.

As mentioned above, before the metal strips which will form the terminals of the integrated circuits are cut to separate the individual devices, the surfaces of the frame which have remained separate are subjected to plating with soldering material.

In a preferred embodiment of the invention, the plating is carried out by immersing the frame in an electrolytic bath of the type normally used to form a copper layer. The composition and operation of this type of electrolytic bath are widely known in the field, and therefore they will not be detailed further in the present description.

After the plating, a wash is carried out to remove impurities and residues of the solution used in the electrolytic bath.

At the end of the washing stage, according to the invention, a remelting stage, in other words a stage of heating and melting the tin layer by means of laser radiation, is carried out.

The laser may be selected from the group of industrial lasers which emit radiation which can be absorbed to a large extent by metals. In practice, a laser of the Nd:YAG CW type, consisting essentially of a crystal of yttrium and aluminium doped with neodymium in the form of a rod having mirrors at its ends, which radiates at a wavelength of 1064 nm (infrared light), has been used with excellent results in the preferred embodiment of the invention. The continuous radiation was converted into the pulsed type (Q-switched) by the production of trains of pulses at a frequency in the range from 5 to 30 kHz and was focused and directed, by a scanning device, on to successive parts of the metal frame intended to form the terminals of the integrated circuits to be soldered.

Thus a selective melting of the tin layer was achieved. In this way the formation of the previously mentioned filaments was avoided, without subjecting the whole structure to damaging overheating and without the risk of short circuits between adjacent terminals.

It was also found that the use of the laser radiation ensured the production of a smooth and morphologically homogeneous plating having a thickness which was no different from the thickness of the plating before the remelting.

It should be noted that the remelting operation according to the present invention can be carried out in the same apparatus as that in which the plating is carried out, and therefore immediately after the stages of application and washing of the tin layer, and consequently, in practice, without any formation of tin oxide.

Thus the further advantage of a process which is simpler than the known ones is obtained, since the fluxing stage required in the plating process according to the prior art can be eliminated.

As may be appreciated from the above description, the process for plating metal parts of semiconductor devices according to the invention can be used to meet the requirements to which reference was made in the introductory part of the present description and, at the same time, to overcome the disadvantages inherent in the plating processes according to the prior art.

Clearly, a person skilled in the art may, in order to meet contingent and specific requirements, make numerous modifications and variations to the process described above, all of these modifications and variations being contained within the scope of the invention as defined by the following claims.

## Claims

1. Process for plating metal parts of semiconductor devices comprising the following stages in succession:
- application of a layer of tin to the metal parts
- heating to a temperature such that at least one predetermined region of the layer of tin is melted
- cooling to a temperature such that the tin melted in the preceding stage is solidified,
characterized in that the said heating is carried out by laser radiation.

2. Process according to Claim 1, in which the stage of application of a layer of tin to the metal parts comprises an electrolytic bath and is followed by a washing stage.

3. Process according to Claim 1 or 2, in which the laser radiation is emitted by an Nd:YAG CW laser with a wavelength of 1064 nm in trains of pulses at a frequency in the range from 5 to 30 kHz.

4. Process according to Claim 2 or 3, in which the stages of application, washing, heating and cooling are carried out in succession in the same apparatus.

5. Use of laser radiation for melting the tin in the process according to any one of the preceding claims.
